(19)

Europäisches
Patentamt
European
Patent Office
Office européen
des brevets

(11) EP 4 362 331 A1

(12) EUROPEAN PATENT APPLICATION

(43) Date of publication:
01.05.2024 Bulletin 2024/18

(21) Application number: 23202746.6

(22) Date of filing: 10.10.2023

(51) International Patent Classification (IPC):
H03F 3/45 (2006.01)          G01R 1/20 (2006.01)
G01R 19/00 (2006.01)          H02J 7/34 (2006.01)

(52) Cooperative Patent Classification (CPC):
G01R 1/203; G01R 19/0092; H02J 7/342;
H03F 2200/297; H03F 2200/45; H03F 2200/453

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 26.10.2022 IT 202200022104

(71) Applicant: STMicroelectronics International N.V.
1228 Plan-les-Ouates, Geneva (CH)

(72) Inventors:
• BIANCHI, Simone
  I-15122 Alessandria (IT)
• POLETTO, Vanni
  I-20151 Milano (IT)

(74) Representative: Bosotti, Luciano
Buzzi, Notaro & Antonielli d'Oulx S.p.A.
Corso Vittorio Emanuele II, 6
10123 Torino (IT)

(54) CURRENT SENSING CIRCUIT, CORRESPONDING SYSTEM AND VEHICLE

(57) A circuit (200') for use, e.g., as current sense amplifier in a DC-DC converter in a hybrid vehicle comprises:

a first input node (INP) and a second input node (INM), configured to have an input voltage signal (IHSEN, ILSEN) applied therebetween,

a floating-ground input stage (IS) configured to operate between a first supply voltage ($V_{LOW}$+5V) and a second non-zero supply voltage ($V_{LOW}$) and to convert into a current signal the input voltage signal applied between the first input node (INP) and the second input node (INM), and

an output stage (OS) configured to receive the current signal from the floating-ground input stage (IS) and to convert the current signal back to an output voltage signal (AMPoutP, AMPoutM) referred to ground (GND).

The output voltage referred to ground is a replica of the input voltage signal applied between the first input node (INP) and the second input node (INM).

FIG. 5

**Description**

Technical field

The description relates to sensing electric currents.
Embodiments as described herein can apply, for instance, to a current sensing amplifier (CSA) for use in hybrid systems for automotive traction that combine an electric motor with an internal combustion engine.

Description of the related art

Innovative 48V (48 Volt) hybrid systems are currently considered for automotive traction applications that include a compact Lithium-ion 48V battery plus a starter/generator. These systems are complementary to conventional 12V (12 Volt) electric networks that equip most of vehicle on-board systems such as lighting.
The designation HEV (an acronym for Hybrid Electric Vehicle) is currently applied to designate vehicles that combine an electric motor with an internal combustion engine (ICE). In so-called "mild" HEVs, the electric motor provides power assist to the ICE and regenerative braking, with no electric-only mode of propulsion provided.
A DC/DC converter can be provided in order to transfer electric energy between such two batteries, e.g., at 48V and 12V.
A desirable feature of such a DC/DC converter is a current sensing amplifier, CSA exhibiting characteristics such as, by way of example:

high input impedance > 1M$\Omega$
wide frequency bandwidth > 50MHz
low input offset voltage error <1mV
low voltage gain error <1%
differential input voltage range = -100mV to +100mV
common mode input voltage range = 0V to 24V

Document US 2016/173045 A1 discloses a current sense amplifier with extended input common mode (CM) voltage range, including an extended CM input voltage amplifier that includes a low voltage (LV) p-type metal oxide semiconductor (PMOS) input module coupled to a positive supply rail, wherein the supply rail provides a voltage that is the maximum between a positive input signal (IN+) applied to the amplifier and an internal power supply voltage. The amplifier further includes a voltage regulator coupled to the supply rail that generates a decreased voltage level relative to the supply rail voltage that is provided to the LV PMOS input module via a high voltage ground (HV_GND) line. At least part of the LV PMOS input module is powered by a voltage difference between the positive supply rail and the HV_GND line. The voltage regulator maintains the voltage difference within an operating range of LV devices within the LV PMOS input module.
Document CN 110 456 141 A discloses a high-side overcurrent detection arrangement wherein a detection circuit comprises a power supply unit, a current hysteresis comparator unit and a level conversion unit. During detection the current hysteresis comparator is connected to two ends of a sampling resistor R1 between a load and a power supply voltage; the current hysteresis comparator unit reversely outputs high and low voltages after inversion and comparison of the load current with set value; the level conversion unit converts the output high and low voltages to output a logic level; the current between the load and the power supply voltage is calculated according to the output logic level. Overcurrent detection is achieved by the current hysteresis comparator unit, the level conversion unit and a single chip microcomputer, and the current hysteresis comparator unit and the level conversion unit are established by adopting a comparator, triodes, resistors and the like.
US 2019/222185 A1 discloses an amplifier that includes a differential positive input, a differential negative input, and a transistor. The transistor is communicatively coupled to the differential positive input and differential negative input at a source of the transistor. The transistor is configured to track input common mode of the differential positive input and differential negative input.
EP 1 691 466 A1 discloses a charger capable of keeping a charging current flowing through a cell constant, of reducing the number of components, and of realizing stable charging by controlling supply power on the output side thereof to be equal to supply power on the input side of a fuel cell. The charger has an output end connected to a secondary cell and uses, as an input source, a cell having relatively large output impedance when electric power is supplied, such as a fuel cell or a solar cell. The charger includes a current control circuit which is connected to the secondary cell and supplies a charging current flowing into the secondary cell as a current value which is obtained from a control value necessary for keeping an output voltage of a converter at a dropping voltage to be set.

Object and summary

One or more embodiments contribute to providing an improved circuit suited for use in current sensing and capable of meeting specifications as listed above by way of example.

According to one of more embodiments, that object is achieved with a circuit (a current sensing amplifier, CSA, for instance) as set forth in the claims that follow.

One or more embodiments relate to a corresponding system. A "mild" hybrid system for automotive traction may be exemplary of such a system.

One or more embodiments relate to a corresponding vehicle. A hybrid electric vehicle, combining an electric motor with an internal combustion engine may be exemplary of such a vehicle.

A noteworthy feature of embodiments as described herein lies in the ability of overcoming the inherent limitation related to differential signals being generated only when inputs are above the floating ground level. Embodiments as described herein are in fact capable of handling input signals below VLOW.

Embodiments as described herein facilitate providing bidirectional DC-DC converters capable of adequately transferring energy between two batteries (e.g., 48V and 12V) in mild hybrid vehicles operating in a multiphase configuration.

Embodiments as described herein can include several (up to six, for instance) power stages or phase subsystems called phase subsystems with each phase subsystem including an inductor and two power transistors that facilitate connecting an inductor alternately to ground and to a first (e.g., 48V) battery in a switch mode.

In embodiments as described herein, each stage can measure (independently of other stages) the current flowing to/from a second (e.g., 12V) battery via a shunt resistor and a differential voltage amplifier operating as a current sense amplifier, CSA.

In embodiments as described herein, a closed loop control is used to regulate the current at the second (e.g., 12V) battery exploiting such current measurement, so that the accuracy of the current measurement directly affects the accuracy of the regulated current.

For instance, in embodiments as described herein, a highest (maximum) tolerated error for the regulated current can be less 1%, with the gain error for the CSA likewise less than 1% and a highest (maximum) input offset that is less than 1mV.

High-frequency noise, due for example to a parasitic inductance of connections, may be present at the input pins of the CSA.

A low-pass filter (LPF) can be provided at the input pins of the CSA. The CSA input current may lead to some voltage drop at the LPF output, in the case this is made of passive (RC) components. In embodiments as described herein, the CSA input pins have low input current (or a high input impedance) and the current flowing to/from the (e.g., 12V) battery has a wide range of variation with positive and negative values, in a range of -50A to + 50A per phase. Consequently, considering a typical 2mΩ shunt resistance, the CSA should desirably operate with a differential input voltage range of, e.g., ±100mV.

The voltage level on a 12V battery may typically vary in the range from 0V to 24V, considering failure modes (open/short) of the 12V battery. Consequently, an extended battery voltage ranging from 0 to 24V is regarded in embodiments as described herein as a common mode input voltage range in which the CSA should desirably operate in an adequate manner.

In embodiments as described herein, the current control loop is very fast in reacting to transients, and for that reason, components with high-speed performance can be included in the loop. For example, an analog-to-digital (ADC) converter can be used having a pipeline architecture with data rates of 40Msps together with a digital controller operating at a 40MHz clock frequency. A CSA as described herein can be included as a component of such a loop, meeting with speed requirements as high as 50MHz in terms of frequency bandwidth.

It is otherwise noted that the quantitative data provided in the foregoing are merely exemplary and non-limiting of the embodiments.

Brief description of the figures

One or more embodiments will now be described, by way of example only, with reference to the annexed figures, wherein:

Figure 1 is a block diagram exemplary of a hybrid system for automotive traction equipping a vehicle such as a motor car;
Figure 2 is a circuit diagram of a related phase subsystem including a current sensing feature;
Figures 3A, 3B and 3C are illustrative of various possible solutions for current sensing;
Figure 4 is a circuit diagram of a (sub)system as illustrated in Figure 2 including a current sensing feature according to embodiments of the present description; and

Figure 5 is a circuit diagram of a current sensing circuit according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

Also, for the sake of simplicity and ease of explanation, throughout this description a same designation may apply to a circuit node or line as well as to a signal occurring at that node or line.

Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments.

The headings/references used herein are provided merely for convenience and hence do not define the extent of protection or the scope of the embodiments.

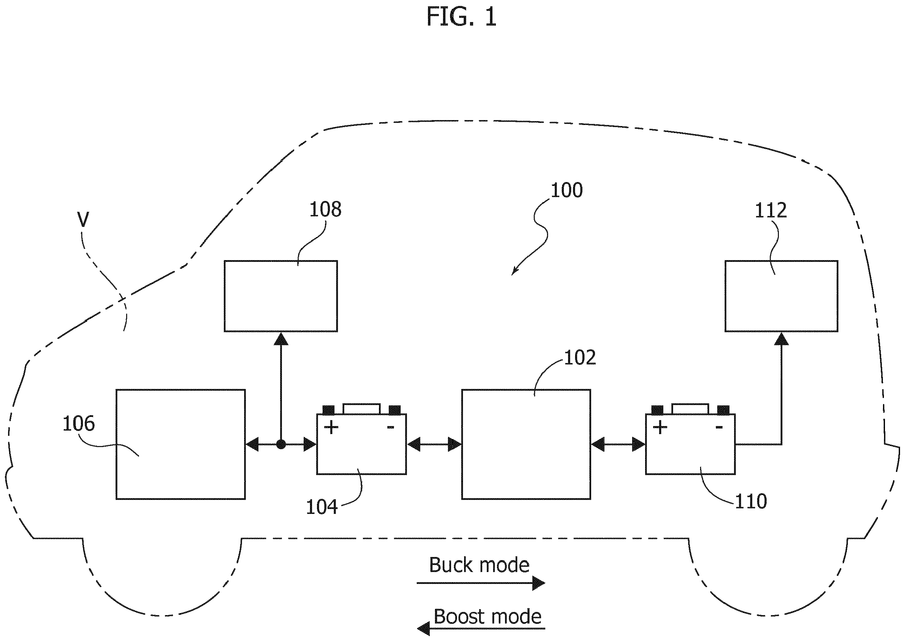

The diagram of Figure 1 is exemplary of a system including a first battery (here the battery 104) and a second battery (here the battery 110), coupled via a DC/DC converter 102 order to facilitate transfer of electric charge therebetween.

For instance, operation of the converter 102 may be in a buck mode in the direction from the battery 104 (here, a higher voltage battery, e.g., a 48V Li-Ion battery) towards the second battery 110 (here, a lower voltage battery, e.g., a 12V lead battery). Operation in the opposite direction can be in a boost mode. A "buck" or "step-down" voltage regulator is one in which the output voltage is lower than its input voltage. A "boost" or "step-up" voltage regulator is one in which the output voltage is higher than its input voltage.

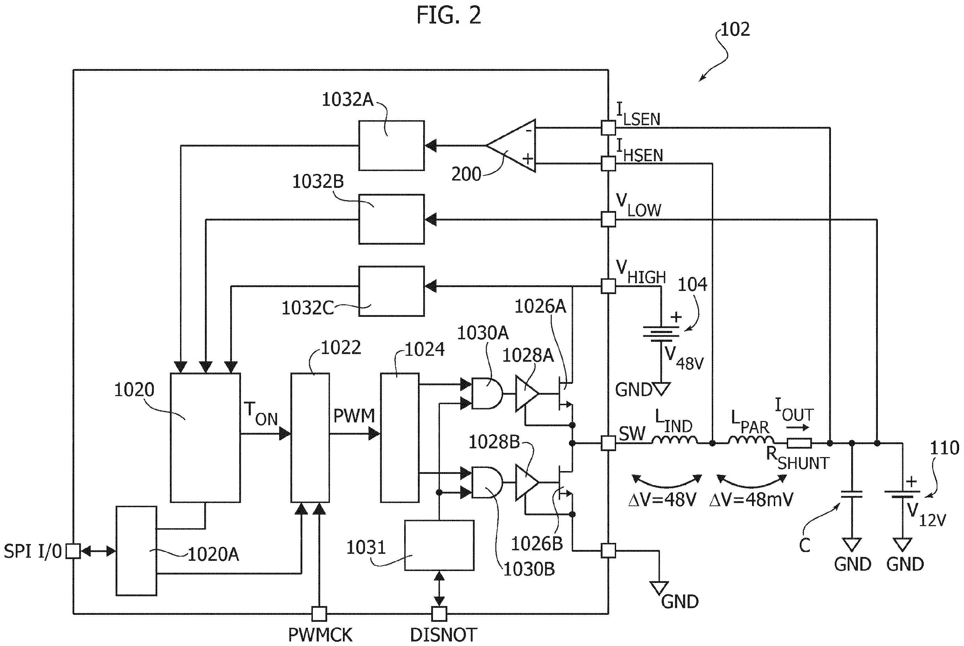

Figure 2 is an exemplary diagram of a possible implementation of converter such as the converter 120.

Operation of such converter is controlled by a controller 1020 coupled to a controller interface 1020A (e.g., a serial peripheral interface, SPI) receiving a SPI I/O signal.

Reference 1022 denotes a synchronization (Synch) and phase shift circuit block clocked by a clock signal PWMCK and configured to produce, based on a Torr signal from the controller 1020 and under the coordination of the controller interface 1020A, a pulse-width-modulated signal PWM.

The PWM signal is applied (via an anti-cross-conduction circuit block 1024) to two electronic switches (e.g., MOSFET transistors) 1026A (high side, HS) and 1026B (low-side, LS). As illustrated, this occurs via drive stages 1028A, 1028B coupled to control terminals (gates, in the case of field-effect transistors such as MOSFETs) of the high-side and low-side transistors 1026A, 1026B. As illustrated, the stages 1028A, 1028B are in turn driven by the anti-cross-conduction circuit block 1024 that receives the pulse-width-modulated signal PWM from the circuit block 1022 gated via AND gates 1030A, 1030B based on gating signals from a bidirectional disable circuit block 1031 that receives a signal DISNOT.

The high-side and low-side transistors 1026A, 1026B are arranged with the current flow paths therethrough (source-drain, in the case of field-effect transistors such as MOSFETs) cascaded in a current flow line between a node $V_{HIGH}$ to which the first (higher voltage) battery 104 is coupled and ground GND.

The controller 1020 acts on the high-side switch 1026A and the low-side switch 1026B making them alternately conductive and non-conductive so that current flows with respect to the second (lower voltage) battery 110 through an inductor $L_{IND}$ coupled to a node SW located between the high-side switch 1026A and the low-side switch 1026B in the current flow line between the node $V_{HIGH}$ and ground GND.

Coupling of second battery 110 (illustrated as having a parallel capacitance C) to the inductor $L_{IND}$ is via a sensing resistor $R_{SHUNT}$ that produces an "amperometry" signal indicative of (the intensity of) the current $I_{OUT}$ through the inductor $L_{IND}$.

As illustrated, the sensing resistor $R_{SHUNT}$ has a (parasitic) series inductance $L_{PAR}$.

The voltage across the sensing resistor $R_{SHUNT}$ (plus the inductance $L_{PAR}$) is applied as a current sensing signal to the inputs $I_{HSEN}$, $I_{LSEN}$ of a (differential) current sense amplifier, CSA 200.

Analog-to-digital converters 1032A, 1032B, and 1032C are supplied with the output from the CSA 200, the voltage at a node $V_{LOW}$ coupled to the (second) battery 110 (and the parallel capacitance C) and the voltage at the node $V_{HIGH}$ coupled to the (first) battery 104, so that these signals are applied as (digital) feedback signals to the controller 1020.

Structure and operation of a system as illustrated in Figure 2 as discussed so far can be regarded as conventional in the art, which makes it unnecessary to provide a more detailed description herein.

It will be appreciated that the batteries 104 and 110 (including the capacitance C) plus the inductor $L_{IND}$ and the current sensing resistor $R_{SHUNT}$ are distinct elements from the converter 102.

It will be otherwise appreciated that embodiments as discussed herein are not primarily concerned with operation of the system in general terms; different options can be adopted for that purpose.

It is noted that, whatever the operating option adopted, the current sensing arrangement including the CSA (200 in Figure 2) plays a significant role in the ultimate performance of the system.

Desirable features for such a CSA include, by way of example:

high input impedance > 1MΩ
wide frequency bandwidth > 50MHz
low input offset voltage error <1mV
low voltage gain error <1%
differential input voltage range = -100mV to +100mV
common mode input voltage range = 0V to 24V.

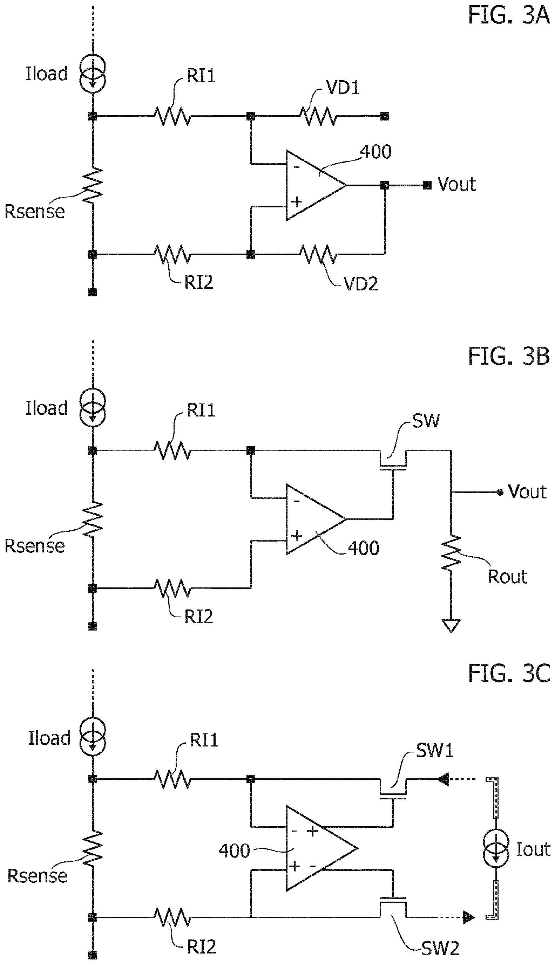

Figures 3A to 3C are exemplary of various possible arrangements that can be used in order to sense (measure) the intensity of a current $I_{LOAD}$ flowing through a sensing resistor $R_{sense}$.

In the arrangements of Figures 3A, 3B, and 3C, a first and a second resistor RI1, RI2 are coupled to the opposite ends of a sensing resistor $R_{sense}$ to apply a corresponding signal across the inverting and non-inverting inputs of a differential sensing amplifier 400.

In the arrangement of Figure 3A, the first resistor RI1 is one branch of a voltage divider including a further resistor VD1 as the other branch. The resistor RI2 is likewise one of the branches of a voltage divider having a resistor VD2 providing another branch coupled to an output node $V_{out}$ of the sensing amplifier 400.

The arrangement of Figure 3B includes a pass transistor (a MOSFET transistor, for instance) having its control terminal (gate, in the case of a field-effect transistor such as a MOSFET) driven by the output of the amplifier 400, and the current flow path therethrough (source-drain, in the case of a field-effect transistor such as MOSFET) coupling the resistor RI1 (and the inverting input of the differential amplifier 400) to the output node $V_{out}$ of the differential amplifier 400 with an output resistor Rout coupled between the output node $V_{out}$, and ground.

In the arrangement of Figure 3C, the amplifier 400 is a fully differential amplifier whose outputs ("+" and "-") drive the control terminals (gates, in the case of field-effect transistors such as MOSFETs) of two transistors acting as pass transistors SW1 and SW2, having the current paths therethrough (source-drain, in the case of field-effect transistors such as MOSFETs) configured to be traversed by an output current $I_{out}$ whose intensity mirrors the intensity of the current $I_{load}$, thus providing a measure thereof.

The arrangements of Figures 3A, 3B and 3C suffer from various drawbacks.

For instance, the arrangement of Figure 3A exhibits a poor operation when the voltage at both inputs, even if identical, is high, this resulting in a high common mode input voltage.

The arrangement of Figure 3B exhibits the same drawbacks, in addition to the unavailability of bi-directional input voltage capability.

The arrangement of Figure 3C somehow palliates the drawbacks discussed in the foregoing at the cost of high input current.

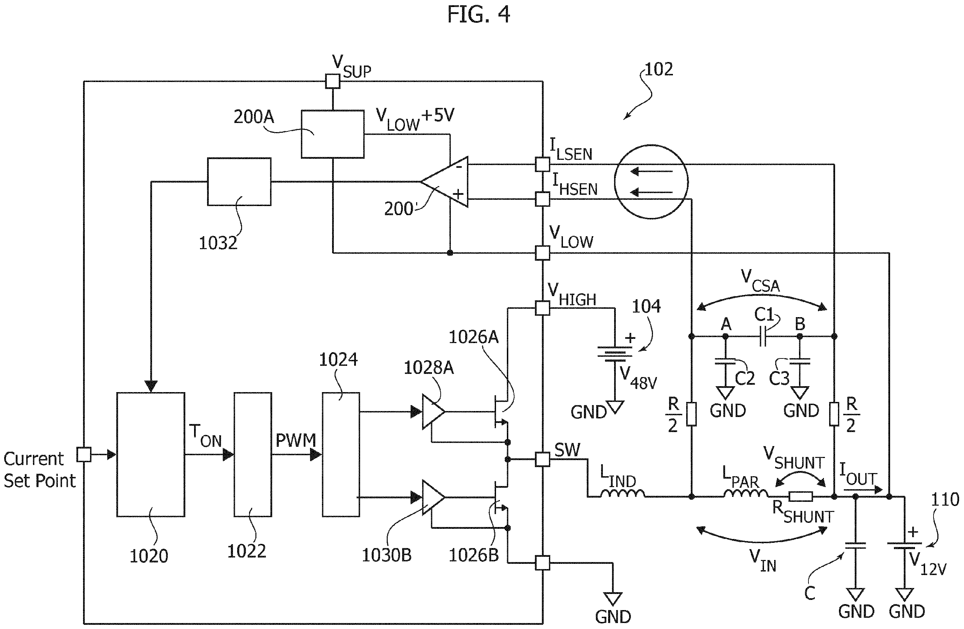

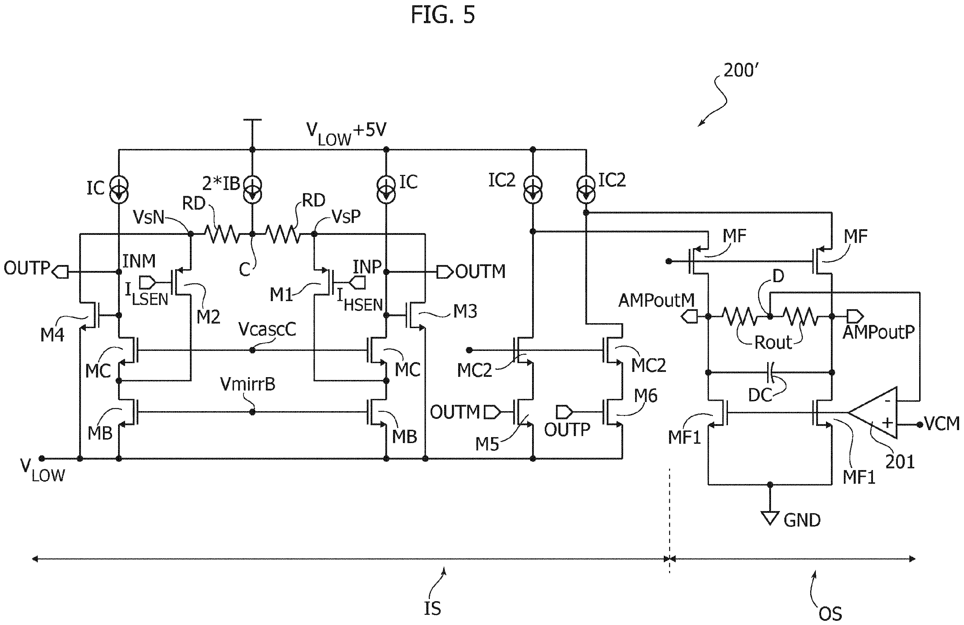

The diagram of Figure 4 illustrates a system as proposed herein that takes advantage, i.e., of a CSA 200', having the features discussed in connection with the diagrams of Figures 5.

The system illustrated in Figure 4 also includes a low-pass filter coupled with the current sensing resistor $R_{SHUNT}$, as further discussed in the following.

In order to facilitate understanding features and advantages of the solution proposed herein, like reference numerals and symbols are used to designate like parts or elements in Figure 2 and Figure 4. It will be otherwise appreciated that, while possibly indicated by a same reference numeral/symbol, parts or elements illustrated in Figure 4 need not necessarily be implemented like corresponding parts or elements illustrated in Figure 2.

By way of general reference (and with certain parts or elements illustrated in Figure 2 not visible in Figure 4 for simplicity of representation) also the DC/DC converter layout of Figure 4 comprises - like the DC/DC converter layout of Figure 2 - a controller 1020 receiving a Current Set Point signal with a synchronization (Synch) and phase shift circuit block 1022 that produces, based on a Torr signal from the controller 1020, a pulse-width-modulated signal PWM. The PWM signal is applied (via an anti-cross-conduction circuit block 1024) to two electronic switches (e.g., GaN transistors) 1026A (high side, HS) and 1026B (low-side, LS) via drive stages 1028A, 1028B coupled to control terminals (gates, in the case of field-effect transistors such as MOSFETs) of the high-side and low-side transistors 1026A, 1026B.

The high-side and low-side transistors 1026A, 1026B are again arranged with the current flow paths therethrough (source-drain, in the case of field-effect transistors such as MOSFETs) cascaded in a current flow line between a node $V_{HIGH}$ to which the first (higher voltage) battery 104 is coupled and ground GND.

The controller 1020 acts on the high-side switch 1026A and the low-side switch 1026B making them alternately conductive and non-conductive so that current flows with respect to the second (lower voltage) battery 110 through an inductor $L_{IND}$ coupled to a node SW located between the high-side switch 1026A and the low-side switch 1026B in the current flow line between the node $V_{HIGH}$ and ground GND.

Coupling of the second battery 110 (illustrated as having a parallel capacitance C) to the inductor $L_{IND}$ is via a sensing resistor $R_{SHUNT}$ that produces an "amperometry" signal indicative of (the intensity of) the current $I_{OUT}$ through the inductor $L_{IND}$.

As illustrated, the sensing resistor $R_{SHUNT}$ has a (parasitic) series inductance $L_{PAR}$.

The voltage across the sensing resistor $R_{SHUNT}$ (plus the inductance $L_{PAR}$) is applied as a current sensing signal to the inputs $I_{HSEN}$, $I_{LSEN}$ of a (differential) current sense amplifier, CSA - here designated 200' - that can be implemented according to the circuit diagram of Figure 5.

The output from the CSA 200' is applied to analog-to-digital converter circuitry 1032 to be supplied as a (digital) feedback signal to the controller 1020.

Differences between the system illustrated in Figure 4 and the system illustrated in Figure 2 comprise primarily the following.

As exemplified in Figure 5, in the system of Figure 4 a differential voltage amplifier 200' is used as the current sense amplifier, CSA, including a "floating" input stage IS supplied with:

the voltage at the node $V_{LOW}$ (essentially the voltage at the battery 110) as a "negative" (lower voltage) supply line, and

a voltage $V_{LOW}$ increased by, e.g., 5V as provided by an associated voltage regulator 200A, as a "positive" (higher voltage) supply line.

The floating input pins of the amplifier 200' of Figure 4 have a common mode input voltage ranging from the voltage of the lower voltage supply line $V_{LOW}$ to the voltage of the higher voltage supply line ($V_{LOW}$ + 5V, for instance).

A floating ground (FG) arrangement was found to facilitate very accurate ground referenced load current measurements.

It is noted that while 5V is exemplified (also in the figures) as the voltage difference between the lower voltage supply line and the higher voltage supply line of the input stage IS, that value is not mandatory.

The floating voltage regulator 200A is provided for supplying the input stage of the CSA 200' with the voltages $V_{LOW}$ (lower supply voltage: as illustrated this may be the voltage at the battery 110) and $V_{LOW}$ + 5V (regulated higher output voltage) based on a positive supply voltage received at a node $V_{SUP}$ where $V_{SUP} > V_{LOW}$ + 5V, for instance.

The differential voltage amplifier 200', acting as the CSA, has an output stage OS supplied with ground (0V) as a lower "negative" supply and, e.g., 5V as a lower "positive" supply. Such an output stage is able to drive the input pin(s) of a standard ADC converter such as the ADC 1032, having itself the same lower negative supply and lower positive supply of the output stage OS. While not explicitly represented in the diagram of Figure 5, the supply of the output stage OS might (also) supply an operational amplifier indicated by 201 as discussed later. An adequate value for this (positive) supply can be +5V over ground (GND, assumed to be at 0V).

In the converter 102 of Figure 4, a low-pass filter arrangement is associated with the shunt resistor $R_{SHUNT}$ for rejecting high-frequency noise: this may be due, e.g., to the parasitic inductance $L_{PAR}$ associated with wiring or connections of the shunt resistor $R_{SHUNT}$, at printed circuit board (PCB).

As illustrated in Figure 4, the low-pass filter arrangement includes:

a first capacitor C1 between nodes A and B, a second capacitor C2 between the node A and ground, plus a third capacitor C3, between the node B and ground, and

resistors of resistance value R/2, between the nodes A and B and opposed ends of the shunt resistor $R_{SHUNT}$.

As illustrated in Figure 4, the voltage between the nodes A and B is applied across the nodes $I_{HSEN}$, $I_{LSEN}$ as a (differential) input to the CSA 200'.

Tuning of the RC low-pass filter in question to adequately cancel high-frequency voltage noise may be according to the following criteria.

The low pass transfer function from $V_{IN}$ (the voltage across the shunt resistor $R_{SHUNT}$ plus the the parasitic inductance $L_{PAR}$) to $V_{SHUNT}$ (the voltage across the shunt resistor $R_{SHUNT}$ alone) can be expressed as:

$$H_{SHUNT}(s) = \frac{V_{SHUNT}(s)}{V_{IN}(s)} = \frac{1}{s\tau_{SHUNT}+1}, \text{ where: } \tau_{SHUNT} = \frac{L_{PAR}}{R_{SHUNT}}$$

The low-pass transfer function from $V_{IN}$ to the input voltage $V_{CSA}$ of the CSA 200'can be expressed as:

$$H_{CSA}(s) = \frac{V_{CSA}(s)}{V_{IN}(s)} = \frac{1}{s\tau_{CSA}+1}, \text{ where: } \tau_{CSA} = RC_1$$

The CSA input voltage $V_{CSA}(s)$ equals the clean shunt resistor output voltage $V_{SHUNT}(s)$ if

$$V_{CSA}(s) = V_{SHUNT}(s) \rightarrow H_{CSA}(s) = H_{SHUNT}(s) \rightarrow \tau_{CSA} = \tau_{SHUNT}$$

Hence the tuning criteria for the low pass RC filter is:

$$RC_1 = \frac{L_{PAR}}{R_{SHUNT}}$$

As illustrated in Figure 5, the CSA 200' proposed herein comprises a first input node INP and a second input node INM configured to have an input voltage signal applied therebetween.

As illustrated, the CSA 200' includes a floating-ground input stage IS configured to operate between a first supply voltage (e.g., $V_{LOW}$+5V) and a second non-zero supply voltage (e.g., $V_{LOW}$) and to convert into a current signal. As illustrated, the current IC2 is a (fixed) bias current, and the signal current is the one mirrored by the transistors M5 and M6, folded down to the output stage through the transistors MF.

More specifically:

the voltage at the pins INP, INM is transferred to the nodes VsP, VsN via the transistors M1, M2;
the voltage at the nodes VsP, VsN is transformed into a current through the two resistors RD and the MOS transistors M3 and M4;
the current of the transistors M3, M4 is reproduced in the transistors M5, M6;
the current through the transistors M5, M6 flows through the transistors MC2, and then through the transistors MF and the two resistors Rout; and
the current through the two resistors Rout gives rise to a voltage across (between) the output nodes AMPoutP, AMPoutN.

The two transistors MF facilitate passing the signal from the "floating" environment of the input stage IS to the output stage OS, which is referred to ground.

As illustrated, the CSA 200' includes an output stage OS configured to receive the current signal from the floating-ground input stage IS and to convert that current signal (back) to an output voltage signal (namely AMPoutP - AMPoutM) referred to ground GND.

That output voltage referred to ground is a replica (and thus a measure) of the input voltage signal applied between the first input node INP and the second input node INM.

A CSA 200' as illustrated in Figures 5 exhibits a high input impedance (virtually no input current) along with a topology suitable for voltage domain changes.

The CSA topology of Figure 5 also exhibits a high input common mode rejection (a differential signal can be amplified in the presence of a large commonmode input, as is the case for burst noise) together with a bi-directional input voltage capability and a high linearity in voltage-to-current conversion.

The CSA 200' illustrated in Figure 5 provides voltage-to-current conversion sharing the advantages discussed in the foregoing in a floating-ground voltage domain (referred to $V_{LOW}$, namely a non-zero voltage) using standard CMOS transistors that facilitate achieving low-power consumption, a moderately low area occupation and good matching.

More in detail, the CSA 200' illustrated in Figure 5 comprises an input transistor pair of a first transistor M1 and a second transistor M2 having control terminals (gates in the case of field-effect transistors such as MOSFETs) coupled to the first input node INP and the second input node INM, respectively.

The first M1 and second M2 transistors in the input transistor pair have respective current flow paths therethrough.

The CSA 200' illustrated in Figure 5 includes two further transistor pairs (namely M3, M4 and M5, M6).

As illustrated, the transistors M3 and M4 are coupled to the first transistor M1 and to the second transistor M2, respectively, in such a way that a difference of the currents flowing through the transistors M3, M4 (and the difference of the currents flowing through the transistors M5, M6 which, as discussed in the following mirror the currents through the transistors M3 and M4) is a function of the input voltage signal applied between the first input node INP and the second input node INM, thus providing a current signal resulting from conversion to a (differential) current signal of the (differential) input voltage signal applied between the first input node INP and the second input node INM.

As exemplified herein, the first M1 and second M2 transistors have respective current flow paths (source-drain, in the case of field-effect transistors such as MOSFETs) therethrough and first and second degeneration resistors RD are provided having a common node C coupled to the first, higher voltage supply line $V_{LOW}$+5V to provide a first bias current 2*IB.

In that way, the current I(M1) in the transistor M1 (and the transistor M2) is constant and equal to I(M1)= I(MB)-IC, where I(MB) denotes the current through the transistors MB. Thus the "signal" current in the transistors M1 and M2 is zero.

The (only) transistors that are traversed by a signal current are thus the transistors M3, M4, M5, M6, MC2 (the two of them) and MF (the two of them). The other transistors have a constant current and thus no signal current flowing therethrough.

The first and second degeneration resistors RD are coupled between their common node C and the current flow path through the first transistor M1 and the current flow path through the second transistor M2, respectively.

The input stage IS of the CSA 200' illustrated in Figure 5 comprises a second transistor pair of a third transistor M3 and a fourth transistor M4 having control terminals (gates, in the case of field-effect transistors such as MOSFETs) coupled to the current flow path (source-drain, in the case of field-effect transistors such as MOSFETs) through the first transistor M1 and to the current flow path through the second transistor M2, respectively.

As illustrated, the first transistor M1 is located between the first degeneration resistor RD and the third transistor M3 while the second transistor M2 is arranged between the second degeneration resistor RD and the fourth transistor M4. In that way, the difference of the currents flowing through the third transistor M3 and through the fourth transistor M4 is a function of the input voltage signal applied between the first input node INP and the second input node INM, and thus represents a current signal resulting from conversion of the input voltage signal applied between the first input node INP and the second input node.

In the exemplary CSA 200' illustrated in Figure 5, the third transistor M3 and the fourth transistor M4 have control terminals (gates, in the case of field-effect transistors such as MOSFETs) coupled to current flow lines for (second) bias currents IC between the first supply line $V_{LOW}$+5V and the second supply line $V_{LOW}$). As illustrated, these current flow lines IC comprise current source transistors MB, arranged between the second supply line $V_{LOW}$ and the current flow path through the first transistor M1 and the current flow path through the second transistor M2, respectively.

Optionally, the circuit 200' comprises cascode transistors MC cascaded to the current source transistors MB, with the current source transistors MB are arranged between the cascode transistors MC and the second supply line $V_{LOW}$.

The input stage IS of the exemplary CSA 200' illustrated in Figure 5, comprises a further transistor pair of a fifth transistor M5 and a sixth transistor M6 that are configured (in a manner known per se to those of skill in the art) to mirror the currents through the third transistor M3 and the fourth transistor M4, respectively.

The (difference of) the currents mirrored via the fifth transistor M5 and a sixth transistor M6 thus again represents (with a possible mirror gain) a current signal resulting from conversion into a current signal of the voltage input signal applied between the first input node INP and the second input node INM.

In the exemplary CSA 200' illustrated in Figure 5, the fifth transistor M5 and the sixth transistor M6 are arranged in current flow lines for (third) bias currents IC2 between the first supply line $V_{LOW}$+5V and the second supply line $V_{LOW}$.

Optionally, the fifth transistor M5 and the sixth transistor M6 have further cascode transistors MC2 cascaded thereto so that the fifth transistor M5 and the sixth transistor M6 are arranged between these further cascode transistors MC2 and the second supply line $V_{LOW}$.

In a solution as exemplified in Figure 5, the voltage signal at the amplifier input (INP - INM, namely $I_{HSEN}$ - $I_{LSEN}$) is thus converted in the input stage IS to a current signal with a high linearity and then folded down in the output stage OS to a low-voltage domain, that is referred to the actual ground GND of the device for further amplification and/or processing.

In a CSA 200' as exemplified in Figure 5, the output stage OS comprises load resistor circuitry (namely the resistors Rout) coupled (via transistors MF) to the input stage IS to be supplied therefrom the current signal resulting from conversion into a current signal of the voltage input node INP and the second input node INM.

As illustrated, the load resistor circuitry is configured to provide across the load resistors Rout circuitry a (differential) output voltage signal $V_{AMPoutP}$ - $V_{AMPoutM}$ that i) is referred to ground GND, and ii) is a replica (thus a highly linear measure) of the input signal applied between the first input node INP and the second input node INM.

As exemplified herein, the load resistor circuitry comprises a first load resistor and a second load resistor Rout

coupled between a common node D and respective current flow lines defined by the cascaded current flow lines (source-drain in the case of field-effect transistors such a MOSFETs through two transistors MF, MF 1) between the input stage IS and ground GND.

As exemplified herein, the output stage OS of the CSA 200' optionally comprises a voltage regulator 201, MF1 coupled to the common node D between the first and the second load resistors Rout.

The current flow lines through the two transistors MF, MF1 to which the load resistors Rout are coupled are coupled to the current flow lines for the third bias currents IC2 through the fifth transistor M5 and through the sixth transistor M6 (currents IC2), respectively.

As illustrated, the current flow lines through the two transistors MF, MF1 between the input stage IS and ground GND comprises current flow paths (source-drain, in the case of field-effect transistors such as MOSFETs) through high-voltage transistors MF, optionally P-type field-effect transistors.

In a CSA 200' as exemplified in Figure 5, use of high-voltage MOS components can thus be limited to two high-voltage MOS components for the voltage domain change (in the output stage OS) without affecting the overall amplifier bandwidth.

The current signal is converted again into a voltage signal across two load resistors Rout that provide an amplification as desired.

An amplifier as illustrated in Figure 5 achieves a clean and precise voltage amplification vs. PVT (process voltage temperature) spread by providing amplifier gain as the ratio between two resistors (RD and Rout) that can be of the same material.

For instance, such a gain can be obtained in two steps:

the input voltage signal (as received between two input nodes INP and INM, e.g., the sensing signal $I_{HSEN}$-$I_{LSEN}$ between the nodes A, B (essentially across the shunt resistor $R_{SHUNT}$) is converted to a current signal in a floating-ground domain (e.g., IS in Figure 5), and

the current signal is converted again into a voltage signal in a groundreferred domain (e.g., OS in Figure 5), achieving a desired amplification target.

As an approach to convert a voltage signal into a resistor-based current signal with a high impedance input, a differential pair (e.g., the transistors M1, M2) with resistive degeneration (e.g., RD) is advantageously used.

In such an arrangement, the two currents through the input differential pair (transistors M1, M2) are kept constant and the actual transconductance gain will not depend on the transconductance of the differential pair so that the linearity of the transconductor may be limited by the overdrive voltage of the input transistors.

As illustrated in Figure 5, the CSA 200' is intended to operate between a higher-voltage supply line $V_{LOW}$ + (e.g., 5V), as provided by the voltage regulator 200A, and a lower-voltage line $V_{LOW}$ (at a non-zero voltage).

In a MOSFET implementation as exemplified in Figure 5, a fully differential circuit is provided including an input pair, e.g., the transistors M1 and M2 that receive the input signals INP, INM at their control terminals (gates in the case of field-effect transistors such as MOSFET transistors) with resistive degeneration as provided by resistors RD.

The resistors RD are arranged between nodes VsP and VsN at the sources of the transistors M1, M2, and a common node C that is coupled the supply line $V_{LOW}$ + 5V to draw therefrom a (first) bias current 2*IB.

Each of the transistors M1, M2 in the input pair has the current flow path therethrough (e.g., the drain, in the case of field-effect transistors such as MOSFET transistors) coupled on the side opposed to the degeneration resistor RD to an intermediate node between a current source transistor MB and a cascode transistor MC.

The current source transistors MB and cascode transistors MC have the current flow paths therethrough (e.g., source-drain, in the case of field-effect transistors such as MOSFET transistors) cascaded in a current flow line between the upper supply line $V_{LOW}$+5V and the lower supply line $V_{LOW}$ to be traversed by (second) bias currents IC.

Output transistor M3, M4 are provided having their control terminals (gates, in the case of a field-effect transistors such as a MOSFET transistors) coupled to the current flow lines traversed by the first bias current (e.g., IC) at the drains of the cascode transistors MC.

The output transistors M3, M4 have the current flow paths therethrough (source-drain in the case of a MOSFET transistor) coupled between a respective one of the nodes VsP, VsN, and ground.

Signals OUTP and OUTM as sensed at the (second) bias current lines IC through the transistors MB and MC (that is, at the gates of the output transistors M3 and M4) are applied to the control terminals (gates in the case of field-effect transistors, such as MOSFET transistors) of two further transistors M5 and M6, each cascaded with a respective cascode transistor MC2 in a current flow line between the higher voltage supply line $V_{LOW}$ + 5V and the lower voltage supply lines $V_{LOW}$ traversed by a (third) bias current IC2.

An advantageous feature of the input stage structure presented in Figure 5 lies in that the current flowing into the transistors M1 and M2 can be kept constant being set at the difference between the drain current of the transistors MB and the bias current IC.

As a consequence, the voltage difference $V_{INP}$-$V_{INM}$ between the voltages at the input nodes INP and INM is transferred to the terminals of the degeneration resistors RD as VsP - VsN.

The body effect of the input pair (transistors M1 and M2) can be cancelled by shorting the body to the source of the transistors.

It is noted that a P-type input pair M1, M2 is optionally chosen for the limited swing of the input signal referred to the lower voltage supply line VLOW. This was found to facilitate a better matching and to provide a lower flicker noise contribution.

In case $V_{INM}$ tends to be higher than $V_{INP}$, the current increases in the transistor M3 and decreases in the transistor M4, so that the difference is maintained equal to [$V_{INP}$-$V_{INM}$]/RD, where RD is the resistance value of the degeneration resistors RD. The value of the (first) bias current, namely IB, can be set considering that the current flowing into the transistors M3 and M4 should desirably be greater than zero for any differential input signal: e.g., $I_{M3}$=IB-0.5*[$V_{INP}$-$V_{INM}$]/RD-($I_{MB}$-IC).

The stability of the loops around the transistors M1 and M2 can be facilitated by two small capacitors (not visible for simplicity) connected from the highimpedance nodes OUTP and OUTM, to the lower voltage supply line $V_{LOW}$.

Once a signal current has been generated, a voltage domain change can be realized by mirroring the currents through the transistors M3 and M4 and folding them down to the ground voltage domain via the transistors M5 and M6.

The transistors M5 and M6 mirror the currents through the transistors M3 and M4 (possibly with amplification).

The two cascode transistors MC2 are optionally added to improve the precision in the mirrored currents.

Finally, two high-voltage transistors MF in the output stage OS are used to fold these currents towards an output branch to provide output signals AMPoutP and AMPoutM so that an output differential voltage signal VAMP$_{outP}$ - VAMP$_{outM}$ becomes available (to be supplied to the ADC converter 1032, for instance) as soon as a differential current flows across two output resistors Rout. The output resistors Rout are coupled each between one of the nodes AMPoutP and AMPoutM and a common node D.

The node D is set to a fixed voltage via the regulator comprising an error amplifier 201 having an inverting input coupled to the node D, and a non-inverting input set to a reference voltage VCM.

The output of the error amplifier 201 drives the mutually-coupled control terminals (gates, in the case of field-effect transistors such as MOSFET transistors) of the two further transistor MF 1 having the current flow paths therethrough (source-drain in the case of field-effect transistors such as MOSFET transistors) cascaded to the current flow path (source-drain, in the case of field-effect transistors such as MOSFET transistors) of the transistors MF.

A capacitor DC can be optionally coupled between the output nodes AMPoutP and AMPoutM with the purpose of limiting the overall amplifier bandwidth if desired.

The overall amplifier voltage gain is thus defined as the ratio of the resistance values of the output and input resistors Rout/RD, multiplied by a mirror ratio between the transistors M3 and M5 (and between the transistors M4 and M6, such mirror ratios being assumed to be equal).

The CSA 200' illustrated in Figure 5 lends itself to being used advantageously in a system for possible use in a vehicle V as exemplified in Figure 1, namely a hybrid motor vehicle equipped with internal combustion engine, ICE traction as well as with electric traction 108 wherein the first battery 104 is coupled to, possibly regenerative, electric traction 108 of the vehicle V. while the second battery 110 supplies on-board equipment such as lighting, advanced driver assistance systems (ADAS), and so on.

In such a system, the first battery 104 may have a first operating voltage and the second battery a second operating voltage, the first operating voltage being optionally higher than the second operating voltage.

For instance, the first battery 104 and the second battery 110 may be a lithium-ion battery and a lead battery, e.g., with operating voltages of 48V and 12V, respectively.

A system as exemplified, e.g., in Figure 4, comprises a DC-DC converter 102 configured to transfer electric charge between the first battery 104 and the second battery 110 via an electric charge transfer line (inductor L$_{IND}$).

Such a DC-DC converter 102 can be controlled via a controller 1020 configured to receive (e.g., via an ADC converter 1032) a sensing signal indicative of the intensity of the current flowing through the electric charge transfer line L$_{IND}$ as sensed via a current sensing resistor R$_{SHUNT}$.

A CSA 200' as exemplified herein can thus be arranged with the first input node INP and the second input node INM coupled across (that is, to opposite ends of) the current sensing resistor R$_{SHUNT}$ to receive the "amperometry" voltage signal I$_{HSEN}$ - I$_{LSEN}$) applied therebetween.

A CSA 200' as exemplified herein can be likewise coupled to the controller 1020 to provide to the controller 1020 (optionally via an analog-to-digital converter 1032, in order to facilitate signal processing in digital format), the output voltage signal referred to ground GND across the load resistors Rout between the nodes AMPoutP, AMPoutM.

That (differential) voltage signal is a replica of the input voltage signal applied between the first input node INP and the second input node INM of the CSA 200' and is thus indicative of the intensity of the current flowing through the electric charge transfer line (inductor L$_{IND}$).

Advantageously, RC low-pass filtering circuitry (namely the resistors R/2 and the capacitors C 1, C2 and C3) is coupled to opposite ends of the current sensing resistor $R_{SHUNT}$ in order to low-pas filter the input voltage signal $V_{CSA}$, between the nodes $I_{HSEN}$ and $I_{LSEN}$ applied between the first input node INP and the second input node INM to the CSA 200'.

As exemplified herein, the low-pass filtering circuitry comprises:

first and second resistors R/2 coupled between opposite ends of the sensing resistor $R_{SHUNT}$ and the first input node INP and the second input node INM, respectively, and
filtering capacitors C1, C2, C3 coupled between:
ground GND and a respective one of the first INP and second INM input nodes and/or between the first input node INP and the second input node INM.

As discussed in the introduction to the present description, a noteworthy feature of embodiments as described herein lies in the ability of overcoming the inherent limitation related to differential signals being generated only when inputs INP e INN are above the floating ground level VLOW. Embodiments as described herein are in fact capable of handling input signals below VLOW.

In fact, by referring to the accompanying figures, and primarily to Figure 5, the configuration made up of the three transistors M1 (or M2, on the other differential side), MC and MB gives rise to a so-called folded-cascode configuration.

In a folded-cascode configuration, a biasing strategy of the transistor MC (VcascC, biasing current IC and aspect ratio of MC) can be selected such that the voltage on the drain of transistor MB (with respect to its source) is as low as possible. The voltage difference between the drain and the source terminals of MB cannot be lower than its saturation voltage. Depending on the technology node, the saturation voltage can be as low as 200 mV.

That rule can be applied to all the transistors depicted in the schematic of the current sensing amplifier (CSA), with all the transistors in their saturation region.

If one considers, for instance, the transistor M1, the gate-source voltage thereof is determined by the aspect ratio and the current flowing through it. Its drain voltage is fixed by MC. Since the gate-source voltage is higher than the saturation voltage (the gate-source voltage can be maximized by a judicious choice of the biasing current and aspect ratio), the gate voltage can go well below VLOW, with the lower limit of the voltage at INP node determined by the saturation voltage limit of M1.

Additionally, one may note that the (at least one) second transistor pair M3, M4 comprises a third transistor (referenced as M3) and a fourth transistor (referenced as M4) having control terminals (gates, in the case of field-effect transistors such as MOSFETs) that are coupled, respectively:

to the current flow path through the first transistor (referenced as M1), and
to the current flow path through the second transistor (referenced as M2).

Advantageously, the gate of the transistor M3 is coupled (via the right-hand cascode transistor MC) to the current flow path (source-drain in the case of field-effect transistor such as a MOSFET) through the first transistor M1 while the gate of the transistor M4 is coupled (via the left-hand cascode transistor MC) to the current flow path (source-drain in the case of field-effect transistor such as a MOSFET) through the second transistor M2.

It is noted that the first transistor M1 is advantageously arranged, with the interposition of the right-hand cascode transistor MC, between the first (right-hand) degeneration resistor RD and the third transistor M3, while the second transistor M2 is advantageously arranged, with the interposition of the left-hand cascode transistor MC, between the second (left-hand) degeneration resistor RD and the fourth transistor M4.

Without prejudice to the underlying principles, the details and embodiments may vary, even significantly, with respect to what has been described in the foregoing, by way of example only, without departing from the extent of protection.

The extent of protection is determined by the annexed claims.

**Claims**

1. A circuit (200'), comprising:

a first input node (INP) and a second input node (INM) configured to have applied therebetween, an input voltage signal (IHSEN, ILSEN) indicative of the intensity of a current flowing through an electrical charge transfer line (LIND) sensed via a current sensing resistor (RSHUNT), the first input node (INP) and the second input node (INM) configured to be coupled to the current sensing resistor (RSHUNT) to receive said input voltage signal (IHSEN, ILSEN) applied therebetween,
a floating-ground input stage (IS) configured to operate between a first supply voltage ($V_{LOW}$+5V) and a second non-zero supply voltage ($V_{LOW}$) and to convert into a current signal the input voltage signal applied between the first input node (INP) and the second input node (INM), and
an output stage (OS) configured to receive the current signal from the floating-ground input stage (IS) and to convert said current signal to an output voltage signal (AMPoutP, AMPoutM) referred to ground (GND), the output voltage referred to ground being a replica of the input voltage signal applied between the first input node (INP) and the second input node (INM)), said output voltage signal (AMPoutP, AMPoutM) referred to ground (GND) being indicative of the current flowing through the electrical charge transfer line (LIND).

2. The circuit of claim 1, wherein the floating-ground input stage (IS) comprises:

a first transistor pair of a first transistor (M1) and a second transistor (M2) having control terminals coupled to the first input node (INP) and the second input node (INM), respectively, the first (M1) and the second (M2) transistors having respective current flow paths therethrough, and
at least one second transistor pair (M3, M4; M5, M6) coupled to the first transistor (M1) and to the second transistor (M2), respectively, wherein a difference of the currents flowing through the transistors in the at least one second transistor pair (M3, M4; M5, M6) is a function of the input voltage signal applied between the first input node (INP) and the second input node (INM).

3. The circuit (200') of claim 2, wherein the first transistor (M1) and the second transistor (M2) comprise P-type field-effect transistors and/or have bodies shorted to the current flow path therethrough.

4. The circuit of claim 2 or claim 3, comprising first and second degeneration resistors (RD) having a common node (C) coupled to the first supply line (VLOW+5V) to provide a first bias current (2*IB), wherein first and second degeneration resistors (RD) are coupled between the common node (C) and the current flow path through the first transistor (M1) and the current flow path through the second transistor (M2), respectively,
wherein the at least one second transistor pair comprises a third transistor (M3) and a fourth transistor (M4) having control terminals coupled to the current flow path through the first transistor (M1) and to the current flow path through the second transistor (M2), respectively, wherein the first transistor (M1) is arranged between the first degeneration resistor (RD) and the third transistor (M3) while the second transistor (M2) is arranged between the second degeneration resistor (RD) and the fourth transistor (M4), wherein a difference of the currents flowing through the third transistor (M3) and through the fourth transistor (M4) is a function of the input voltage signal applied between the first input node (INP) and the second input node (INM).

5. The circuit (200') of claim 4, wherein the third transistor (M3) and the fourth transistor (M4) have control terminals coupled to current flow lines for second bias currents (IC) between the first supply line ($V_{LOW}$+5V) and the second supply line ($V_{LOW}$), said current flow lines for said second bias currents (IC) comprising current source transistors (MB), arranged between the second supply line ($V_{LOW}$) and the current flow path through the first transistor (M1) and the current flow path through the second transistor (M2), respectively, the circuit (200') preferably comprising cascode transistors (MC) cascaded to said current source transistors (MB) in said current flow lines for second bias currents (IC), wherein said current source transistors (MB) are arranged between said cascode transistors (MC) and the second supply line ($V_{LOW}$).

6. The circuit (200') of claim 4 or claim 5, wherein the at least one second transistor pair comprises a fifth transistor (M5) and a sixth transistor (M6) arranged in current flow lines for third bias currents (IC2) between the first supply line (VLOW+5V) and the second supply line (VLOW), the fifth transistor (M5) and the sixth transistor (M6) being configured to mirror the currents through the third transistor (M3) and the fourth transistor (M4), respectively, and provide said current signal resulting from conversion of the voltage input signal applied between the first input node (INP) and the second input node (INM).

7. The circuit (200') of claim 6, wherein the fifth transistor (M5) and the sixth transistor (M6) have further cascode transistors (MC2) cascaded thereto with the fifth transistor (M5) and sixth transistor (M6) arranged between the second supply line ($V_{LOW}$) and said further cascode transistors (MC2).

8. The circuit (200') of any of the previous claims, comprising a voltage regulator (200A) configured to produce the first supply voltage ($V_{LOW}$+5V) from the second supply voltage ($V_{LOW}$).

9. The circuit (200') of any of the previous claims, wherein the output stage (OS) comprises load resistor circuitry (Rout) coupled (M5, M6; MF) to the input stage (IS) to be supplied therefrom the current signal resulting from conversion into a current signal of the voltage input node (INP) and the second input node (INM), wherein the load resistor circuitry (Rout) is configured to provide across the load resistor circuitry (Rout) the output voltage signal (AMPoutP, AMPoutM) referred to ground (GND) which is a replica of the input signal applied between the first input node (INP) and the second input node (INM).

10. The circuit (200') of claim 9, wherein the load resistor circuitry comprises a first load resistor (Rout) and a second load resistor (Rout) coupled between a common node (D) and respective current flow lines (MF, MF1) between the input stage (IS) and ground (GND), the circuit preferably comprising a voltage regulator (201, MF1) coupled to the common node (D) between the first and the second load resistors (Rout).

11. The circuit (200') of claim 6 and claim 10, wherein the respective current flow lines (MF) having the first load resistor and the second load resistor (Rout) coupled thereto are further coupled to the current flow lines for the third bias currents (IC2) through the fifth transistor (M5) and through the sixth transistor (M6), respectively.

12. The circuit (200') of claim 10 or claim 11, wherein the current flow lines (MF, MF1) between the input stage (IS) and ground (GND) comprises current flow paths through high-voltage transistors (MF), preferably P-type field-effect transistors.

13. A system comprising:

   a first battery (104),
   a second battery (110),
   a DC-DC converter (102) configured to transfer electric charge between the first battery (104) and the second battery (110) via an electric charge transfer line ($L_{IND}$), the DC-DC converter (202) controlled via a controller (1020) configured (1032) to receive a sensing signal indicative of the intensity of the current flowing through the electric charge transfer line ($L_{IND}$) sensed via a current sensing resistor ($R_{SHUNT}$),
   wherein the system comprises a circuit (200') according to any of the previous claims, the circuit (200') having the first input node (INP) and the second input node (INM) coupled to opposite ends of the current sensing resistor ($R_{SHUNT}$) to receive said input voltage signal ($I_{HSEN}$, $I_{LSEN}$) applied therebetween, the circuit (200') coupled (1032) to the controller (1020) to provide to the controller (1020), preferably via an analog-to-digital converter (1032), the output voltage signal (AMPoutP, AMPoutM) referred to ground (GND) that is a replica of the input voltage signal applied between the first input node (INP) and the second input node (INM) to said circuit (200'), said output voltage signal (AMPoutP, AMPoutM) referred to ground (GND) being indicative of the intensity of the current flowing through the electric charge transfer line ($L_{IND}$).

14. The system of claim 13, comprising low-pass filtering circuitry (R/2; C1, C2, C3) coupled to opposite ends of the current sensing resistor ($R_{SHUNT}$), the low-pass filtering circuitry configured to low-pass filter said input voltage signal ($V_{CSA}$, $I_{HSEN}$, $I_{LSEN}$) applied between the first input node (INP) and the second input node (INM) to said circuit (200'), the low-pass filtering circuitry preferably comprising RC low-pass filtering circuitry.

15. The system of claim 14, wherein the low-pass filtering circuitry comprises:

   first and second resistors (R/2) coupled between opposite ends of the sensing resistor ($R_{SHUNT}$) and the first input node (INP) and the second input node (INM), respectively, to said circuit (200'), and
   filtering capacitors (C1, C2, C3) coupled between ground (GND) and a respective one of the first (INP) and second (INM) input nodes to said circuit (200') and/or between the first input node (INP) and the second input node (INM) to said circuit (200').

16. The system of any of claims 13 to 15, wherein the first battery (104) has a first operating voltage and the second battery (110) has a second operating voltage, the first operating voltage being higher than the second operating voltage,

17. The system of any of claims 13 to 16, wherein the first battery (104) and the second battery (110) are a lithium-ion battery and a lead battery, preferably with operating voltages of 48V and 12V, respectively.

18. A hybrid motor vehicle (V) equipped with internal combustion engine traction (118) as well as with electric traction (108) and a system according to any of claims 13 to 17 wherein the first battery (104) is coupled to the electric traction (108) of the vehicle (V).

FIG. 1

Buck mode

Boost mode

EP 4 362 331 A1

FIG. 2

EP 4 362 331 A1

FIG. 3A

FIG. 3B

FIG. 3C

FIG. 4

EP 4 362 331 A1

FIG. 5

EP 4 362 331 A1

Europäisches
Patentamt

European
Patent Office

Office européen
des brevets

## EUROPEAN SEARCH REPORT

**Application Number**

EP 23 20 2746

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/173045 A1 (CREOSTEANU LAURENTIU O [RO] ET AL) 16 June 2016 (2016-06-16) | 1-3,9, 10,12-18 | INV. H03F3/45 |
| Y | * paragraphs [0026], [0035]; figures | 4-7 | G01R1/20 |
| A | 1c,2,4 * | 8,11 | G01R19/00 H02J7/34 |
| | ----- | | |
| X | CN 110 456 141 A (ANHUI GVB RENEWABLE ENERGY TECH CO LTD) 15 November 2019 (2019-11-15) * abstract; figures 1,2 * | 1 | |
| | ----- | | |
| Y | US 7 202 738 B1 (HUIJSING JOHAN HENDRIK [NL] ET AL) 10 April 2007 (2007-04-10) * column 1, lines 13-57; figure 8 * | 4-7 | |
| | ----- | | |
| A | EP 1 691 466 A1 (SHINDENGEN ELECTRIC MFG [JP]) 16 August 2006 (2006-08-16) * abstract; figure 11 * | 13-17 | |
| | ----- | | |

**TECHNICAL FIELDS SEARCHED (IPC)**

G01R
H03F
H02J

The present search report has been drawn up for all claims

| Place of search | Date of completion of the search | Examiner |
|---|---|---|
| The Hague | 14 March 2024 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 20 2746

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2024

| Patent document cited in search report | | Publication date | Patent family member(s) | | Publication date |
|---|---|---|---|---|---|
| US 2016173045 | A1 | 16-06-2016 | CN | 205194327 U | 27-04-2016 |
| | | | DE | 202015106708 U1 | 26-01-2016 |
| | | | US | 2016173037 A1 | 16-06-2016 |
| | | | US | 2016173045 A1 | 16-06-2016 |
| CN 110456141 | A | 15-11-2019 | NONE | | |
| US 7202738 | B1 | 10-04-2007 | NONE | | |
| EP 1691466 | A1 | 16-08-2006 | EP | 1691466 A1 | 16-08-2006 |
| | | | JP | 4152413 B2 | 17-09-2008 |
| | | | JP | WO2005050813 A1 | 06-12-2007 |
| | | | KR | 20060059975 A | 02-06-2006 |
| | | | US | 2007108943 A1 | 17-05-2007 |
| | | | WO | 2005050813 A1 | 02-06-2005 |

EPO FORM P0459

For more details about this annex : see Official Journal of the European Patent Office, No. 12/82

**EP 4 362 331 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016173045 A1
- CN 110456141 A
- US 2019222185 A1
- EP 1691466 A1